# EUROPEAN PATENT APPLICATION

(11) **EP 4 618 151 A1**
(43) Date of publication of application: **17.09.2025**
(21) Application number: 23888841.6
(22) Date of filing: 26.06.2023
(51) Int. Cl.: H01L 25/065, H01L 23/498, H01L 25/18, H01L 23/538, H01L 23/00

(54) **SEMICONDUCTOR DEVICE AND SEMICONDUCTOR PACKAGE COMPRISING SAME**

(30) Priority: 11.11.2022 KR 20220150700; 26.12.2022 KR 20220184153
(71) Applicant: Electronics and Telecommunications Research Institute, Daejeon 34129 (KR)
(72) Inventor: KWON, Young-Su, Daejeon 34129 (KR)
(74) Representative: Betten & Resch
(86) International application number: PCT/KR2023/008822
(87) International publication number: WO 2024/101572

(57) **Abstract**

A semiconductor device according to an embodiment of the present disclosure may include an interposer, a High Bandwidth Memory (HBM) module and a semiconductor module disposed to be spaced apart from each other on the top of the interposer, and an HBM switch chiplet disposed under the interposer and configured to electrically connect the HBM module and the semiconductor module.

## Description

### Technical Field

The present disclosure relates generally to a semiconductor device and a semiconductor package comprising same, and more particularly, to a chiplet semiconductor architecture.

This application claims the benefit of Korean Patent Applications No. 10-2022-0150700, filed November 11, 2022, and No. 10-2022-0184153, filed December 26, 2022, which are hereby incorporated by reference in their entireties into this application.

### Background Art

Current Artificial Intelligence (AI) is implemented using artificial neural networks (NNs). Since the artificial neural network called 'AlexNet' emerged, the scale of an artificial neural network has been continuously growing into a 'hyperscale artificial neural network' (with more than 100 billion parameters) after a transformer-structure neural network.

Training and inference of an artificial neural network are configured to perform a large number of mathematical operations on parameters and input data, and with the increasing scale of the artificial neural networks, 300 zettaflops (300 × 10²¹ operations) are required to train such hyperscale artificial neural networks.

In order to train the hyperscale artificial neural network, semiconductors are required to have ultrahigh performance. Particularly, semiconductors having the capability of reading and writing huge amounts of data in a short period of time, that is, semiconductors having advanced data performance, are required, and High Bandwidth Memory (HBM), which is stacked Dynamic Random Access Memory (DRAM), is being adopted therefor.

A chiplet semiconductor, which is a future semiconductor architecture, has a structure in which multiple Central Processing Unit (CPU) or Neural Processing Unit (NPU) dies for improving computing performance are connected with multiple HBM dies for improving data performance through ultrahigh-density wire so as to operate as a single semiconductor.

A conventional AI semiconductor includes an NPU and HBM, and the NPU and the HBM connect a signal through an interposer by installing a bump having the same structure as the signal bump of the HBM in the NPU, in which case the length of a signal line is about 6 mm, which increases the resistance of the signal line.

When the resistance of the signal line increases, the signal line cannot transfer a high-speed signal, and because the transfer rate of a signal between the NPU and the HBM reaches several Gbps (transmitting one billion bits per second, 6.4 Gbps in the case of HBM3), the length of the signal line is a crucial obstacle (limitation) to data transmission.

Also, because several thousands of signal bumps of the HBM (1024 signal bumps in the case of HBM3) are used for 'Wide IO' configuration, it is necessary to implement the same number of signal bumps in the NPU die so as to be symmetrical (mirrored) thereto, which results in a substantial increase in the size of an NPU chiplet.

### Disclosure

### Technical Problem

An object of the present disclosure is to provide a semiconductor device for efficiently connecting HBM to a CPU or an NPU and a semiconductor package comprising semiconductor device in order to improve data performance of the memory.

### Technical Solution

In order to accomplish the above object, a semiconductor device according to an embodiment may include an interposer, an HBM module and a semiconductor module disposed to be spaced apart from each other on the top of the interposer, and an HBM switch chiplet disposed under the interposer and configured to electrically connect the HBM module and the semiconductor module.

The HBM switch chiplet may include a first connection wire configured to electrically connect the HBM switch chiplet and the HBM module by passing through the interposer.

The first wire may perpendicularly pass through the interposer.

The length of the first wire may be 40 to 50 µm.

The HBM switch chiplet may include a second connection wire configured to electrically connect the HBM switch chiplet and the semiconductor module by passing through the interposer.

The second connection wire may include a shield wire.

The second connection wire may include at least one vertical part and at least one horizontal part.

A number of ground wires corresponding to the number of second connection wires may be included.

The ground wires may be connected to the interposer.

A number of HBM switch chiplets corresponding to the number of HBM modules may be disposed.

Also, in order to accomplish the above object, a semiconductor package according to an embodiment may include a base substrate, an interposer disposed on the base substrate, an HBM module and a semiconductor module disposed to be spaced apart from each other on the top of the interposer, and an HBM switch chiplet disposed under the interposer and configured to electrically connect the HBM module and the semiconductor module.

The HBM switch chiplet may include a first connection wire configured to electrically connect the HBM switch chiplet and the HBM module by passing through the interposer.

The first wire may perpendicularly pass through the interposer.

The length of the first wire may be 40 to 50 µm.

The HBM switch chiplet may include a second connection wire configured to electrically connect the HBM switch chiplet and the semiconductor module by passing through the interposer.

The second connection wire may include a shield wire.

The second connection wire may include at least one vertical part and at least one horizontal part.

A number of ground wires corresponding to the number of second connection wires may be included.

The ground wires may be connected to the interposer.

A number of HBM switch chiplets corresponding to the number of HBM modules may be disposed.

### Advantageous Effects

An embodiment may reduce a bump area in an NPU for sending and receiving data to and from HBM because a connection wire between the NPU and an HBM switch chiplet is implemented with a small number of shield wires.

Also, an embodiment may maintain signal integrity because the resistance of a signal line is minimized by forming the wire between HBM and an HBM switch chiplet in a three-dimensional (3D) vertical structure.

Also, an embodiment may configure an NPU such that the NPU is able to transmit and receive data to and from multiple HBM units while minimizing the area of the die of the NPU.

### Description of Drawings

FIG. 1 is a perspective view illustrating a semiconductor device according to an embodiment.
FIG. 2 is a cross-sectional view illustrating an interposer of a semiconductor device according to an embodiment.
FIG. 3 is a cross-sectional view illustrating a structure in which an HBM module and an HBM switch chiplet are connected according to an embodiment.
FIG. 4 is a cross-sectional view illustrating a structure in which an NPU module and an HBM switch chiplet are connected according to an embodiment.
FIG. 5 is a perspective view illustrating a semiconductor package including a semiconductor device according to an embodiment.

### Best Mode

The advantages and features of the present disclosure and methods of achieving them will be apparent from the following exemplary embodiments to be described in more detail with reference to the accompanying drawings. However, it should be noted that the present disclosure is not limited to the following exemplary embodiments, and may be implemented in various forms. Accordingly, the exemplary embodiments are provided only to disclose the present disclosure and to let those skilled in the art to which the present disclosure pertains know the category of the present disclosure, and the present disclosure is to be defined based only on the claims. The same reference numerals or the same reference designators denote the same elements throughout the specification.

It will be understood that, although the terms "first," "second," etc. may be used herein to describe various elements, these elements are not intended to be limited by these terms. These terms are only used to distinguish one element from another element. For example, a first element discussed below could be referred to as a second element without departing from the technical spirit of the present disclosure.

The terms used herein are for the purpose of describing particular embodiments only and are not intended to limit the present disclosure. As used herein, the singular forms are intended to include the plural forms as well, unless the context clearly indicates otherwise. It will be further understood that the terms "comprises," or "comprising," when used herein, specify the presence of stated components or steps, but do not preclude the presence or addition of one or more other components, steps, and/or groups thereof.

Unless differently defined, all terms used herein have the same meanings as terms generally understood by those skilled in the art to which the present disclosure pertains. Terms identical to those defined in generally used dictionaries are not to be interpreted as having ideal or excessively formal meanings unless they are definitively defined in the present specification.

In the present specification, each of expressions such as "A or B", "at least one of A and B", "at least one of A or B", "at least one of A, B, and C", and "at least one of A, B, or C" may include any one of the items listed in the expression or all possible combinations thereof.

Hereinafter, embodiments of the present disclosure will be described in detail with reference to the accompanying drawings. In the following description of the present disclosure, the same reference numerals are used to designate the same or similar elements throughout the drawings, and repeated descriptions of the same elements will be omitted.

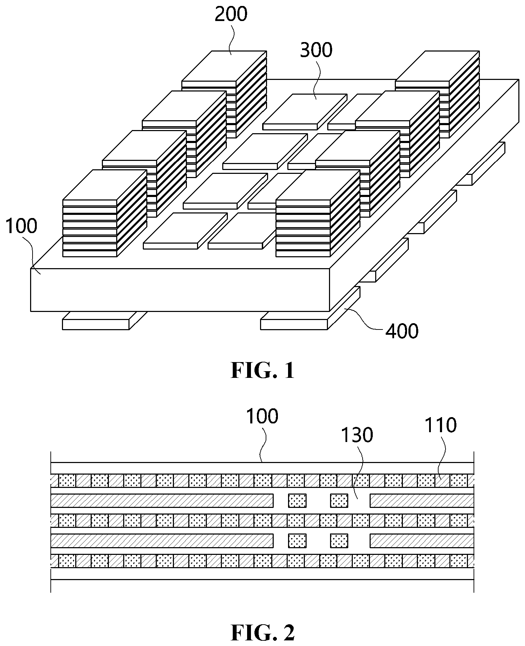

FIG. 1 is a perspective view illustrating a semiconductor device according to an embodiment.

Referring to FIG. 1, the semiconductor device according to an embodiment may include an interposer 100, an HBM module 200, an NPU 300, which is a semiconductor module, and an HBP switch chiplet 400.

The interposer 100 may be a module for implementing high-density wiring for connecting the HBM module 200 and the NPU 200 with each other when the HBM module 200 and the NPU 300 are arranged in a two-dimensional (2D) plane. The interposer 100 may include wiring in the form of redistribution layer (RDL), silicon (through silicon via (TSV)), an organic printed circuit board (PCB) or non-TSV-based embedded multi-die interconnect bridge (EMIB). When the interposer 100 is implemented in the form of RDL, bumps may be formed over and under the interposer without TSVs, so dies may be implemented over and under the interposer.

FIG. 2 is a cross-sectional view illustrating an interposer of a semiconductor device according to an embodiment.

As illustrated in FIG. 2, the interposer 100 is formed in a polygonal shape, and may include a conductive material 110 and a polymer insulator 130 therein.

The conductive material 110 may be formed in multiple layers. The conductive material 110 may include at least one material selected from among Cu, a Cu alloy, such as CuSn, CuMg, CuNi, CuZn, CuPd, CuAu, CuRe, CuW, or the like, W, a W alloy, Ni, Ru, and Co, but is not limited thereto.

The polymer insulator 130 may be disposed between the conductive materials. The polymer insulator may be formed of an oxide film, a nitride film, a carbide film, a polymer, or a combination thereof, but is not limited thereto.

Referring back to FIG. 1, the HBM module 200 is memory formed through high-speed stacking of DRAM dies, and may have a stacked die structure. The HBM module 200 may be formed along the edges of the interposer 100 by being mounted on the interposer 100, but the position thereof is not limited.

In the case of HBM3, there are 7600 micro-bumps under the HBM module 200, and the micro-bump may be configured with a signal bump and a power bump.

When an AI semiconductor operates, the data that the NPU 300 requires for an AI operation is stored in the HBM module 200. When the NPU 300 and the HBM module 200 send and receive data, the data may be transmitted through a signal connected between the NPU 300 of the HBM module 200 and the HBM module 200.

The power bump of the HBM module 200 is a bump for supplying power to the HBM module 200, and the power bump may be connected to a substrate through the interposer 100.

A semiconductor module may be formed of a device other than a Neural Processing Unit (NPU). For example, the semiconductor module may execute specialized operations by including at least one of a Central Processing Unit (CPU), an Application Processor (AP), a Graphic Processing Unit (GPU), a Tensor Processing Unit (TPU), a Vision Processing Unit (VPU), an Image Signal Processor (ISP), or a Digital Signal Processor (DSP), or a combination thereof.

The NPU 300 is a semiconductor for performing mathematical operations required for training and inference of an artificial neural network of Artificial Intelligence (AI), and may be configured with a floating-point unit for an artificial neural network operation.

The NPU 300 may comprise a plurality of NPUs 300, and the plurality of NPUs 300 may be horizontally arranged on the interposer 100. The NPU 300 may be arranged to be enclosed by the HBM module 200, but the position thereof is not limited.

The HBM switch chiplet 400 may be mounted under the interposer 100. The HBM switch chiplet 400 is a semiconductor die, the width and height of which are greater than those of the HBM module 200, and may have a size corresponding to the area of the HBM signal bump.

The HBM switch chiplet 400 may transfer a signal between the HBM module 200 and the NPU 300. The HBM switch chiplet 400 may be electrically connected with the HBM module 200. The HBM switch chiplet 400 may be electrically connected with the NPU 300.

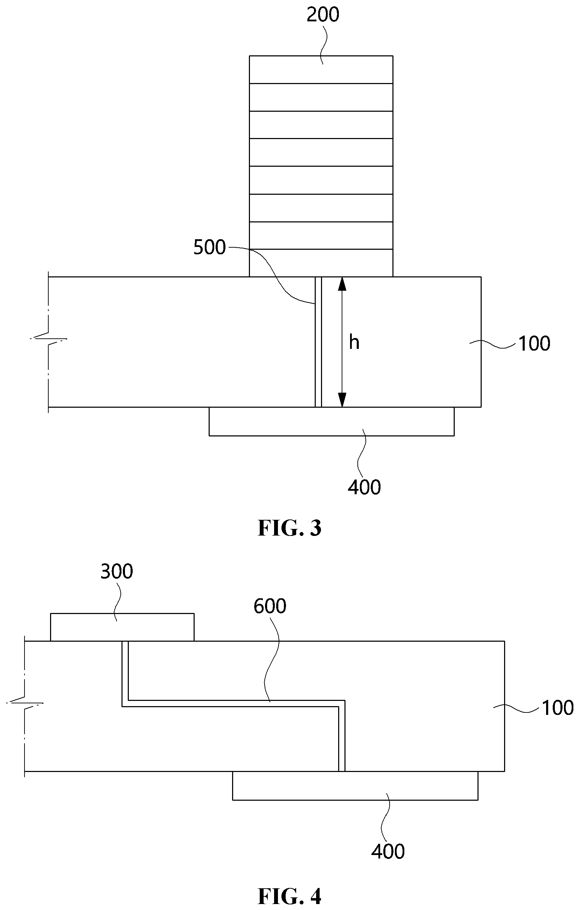

FIG. 3 is a cross-sectional view illustrating a structure in which an HBM module and an HBM switch chiplet are connected according to an embodiment.

As illustrated in FIG. 3, a first connection wire 500 for electrically connecting the HBM switch chiplet 400 and the HBM module 200 may be disposed in the HBM switch chiplet 400. The first connection wire 500 may be connected with the HBM module 200 by passing through the interposer 100 from the top of the HBM switch chiplet 400. The first connection wire 500 may be disposed to be perpendicular to the top surface of the HBM switch chiplet 400. The length (h) of the first connection wire 500 may be 40 to 50 µm.

Because the length (h) of the first connection wire 500 is about 1/120 of the length of the conventional one, the data transfer performance degradation caused by the resistance of the signal line may be prevented. The first connection wire 500 may be formed in any of various shapes, but it is effective to dispose the first connection wire 500 to be perpendicular to the top surface of the HBM switch chiplet 400 in order to minimize the resistance of the signal line.

FIG. 4 is a cross-sectional view illustrating a structure in which an NPU module and an HBM switch chiplet are connected according to an embodiment.

As illustrated in FIG. 4, a second connection wire 600 for electrically connecting the HBM switch chiplet 400 with the NPU 300 may be disposed in the HBM switch chiplet 400. The second connection wire 600 may be connected with the NPU 300 by passing through the interposer 100 from the top of the HBM switch chiplet 400. The second connection wire 600 may be formed of at least one vertical part and at least one horizontal part, but the shape thereof is not limited.

Because the second connection wire 600 transfers a signal at high speeds (24 Gbps in the case of HBM 3) by being implemented with 256 shield wires, the number of wires may be reduced to 1/4 compared to conventional ones.

Because the second connection wire 600 between the NPU 300 and the HBM switch chiplet 400 may provide high speeds depending on the ratio by which the number of second connection wires 600 is decreased, it may be implemented as 'one-by-one shielded wire'. That is, each ground wire may be disposed for each second connection wire.

The ground wire is connected to the ground plane of the interposer, and a bump for shield wire does not exist in the NPU.

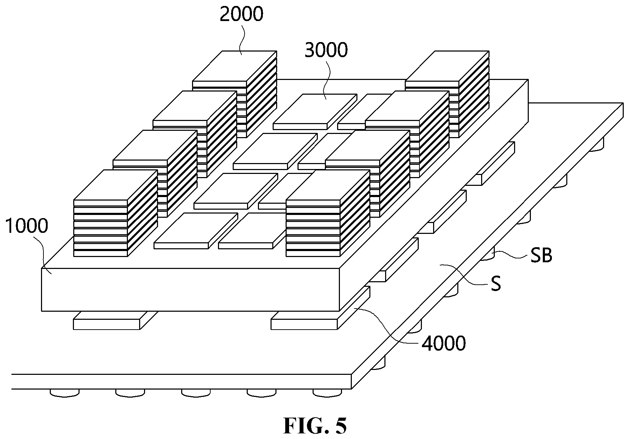

FIG. 5 is a perspective view illustrating a semiconductor package including a semiconductor device according to an embodiment.

Referring to FIG. 5 the semiconductor device according to an embodiment may include an interposer 1000, an HBM module 2000, an NPU 3000, which is a semiconductor module, an HBP switch chiplet 4000, and a semiconductor substrate S.

The interposer 1000 may be a module for implementing high-density wiring for connecting the HBM module 2000 and the NPU 2000 with each other when the HBM module 2000 and the NPU 3000 are arranged in a 2D plane. The interposer 100 may include wiring in the form of RDL, silicon (TSV), an organic PCB or non-TSV-based embedded multi-die interconnect bridge (EMIB). When the interposer 1000 is implemented in the form of RDL, because bumps may be formed over and under the interposer without TSVs, dies may be implemented over and under the interposer.

The interposer 1000 is formed in a polygonal shape, and may include a conductive material and a polymer insulator therein.

The HBM module 2000 is memory formed through high-speed stacking of DRAM dies, and may have a stacked die structure. The HBM module 2000 may be formed along the edges of the interposer 1000 by being mounted on the interposer 1000, but the position thereof is not limited..

In the case of HBM3, there are 7600 micro-bumps under the HBM module 2000, and the micro-bump may be configured with a signal bump and a power bump.

When an AI semiconductor operates, the data that the NPU 3000 requires for an AI operation is stored in the HBM module 2000. When the NPU 3000 and the HBM module 2000 send and receive data, the data may be transmitted through a signal connected between the NPU 3000 of the HBM module 2000 and the HBM module 2000.

The NPU 3000 is a semiconductor for performing mathematical operations required for training and inference of an artificial neural network of AI, and may be configured with a floating-point unit for an artificial neural network operation.

The NPU 3000 may comprise a plurality of NPUs 3000, and the plurality of NPUs 3000 may be horizontally arranged on the interposer 1000. The NPU 3000 may be arranged to be enclosed by the HBM module 2000, but the position thereof is not limited.

The HBM switch chiplet 4000 may be mounted under the interposer 1000. The HBM switch chiplet 4000 is a semiconductor die, the width and height of which are greater than those of the HBM module 2000, and may have a size corresponding to the area of the HBM signal bump.

The semiconductor substrate S may fix the semiconductor device. The power bump of the HBM module 2000 may be connected to the semiconductor substrate S through the interposer 1000. Solder bumps SB are disposed under the semiconductor substrate S, thereby fixing the semiconductor device. Also, the solder bump SB is electrically connected with the semiconductor device, whereby a signal may be transferred to the outside through the solder bump SB.

The HBM switch chiplet 4000 may transfer a signal between the HBM module 2000 and the NPU 3000. The HBM switch chiplet 4000 may be electrically connected with the HBM module 2000 through a first connection wire. The HBM switch chiplet 4000 may be electrically connected with the NPU 3000 through a second connection wire.

Specific implementations described in the present disclosure are embodiments and are not intended to limit the scope of the present disclosure. For conciseness of the specification, descriptions of conventional electronic components, control systems, software, and other functional aspects thereof may be omitted. Also, lines connecting components or connecting members illustrated in the drawings show functional connections and/or physical or circuit connections, and may be represented as various functional connections, physical connections, or circuit connections that are capable of replacing or being added to an actual device. Also, unless specific terms, such as "essential", "important", or the like, are used, the corresponding components may not be absolutely necessary for application of the present disclosure.

Accordingly, the spirit of the present disclosure should not be construed as being limited to the above-described embodiments, and the entire scope of the appended claims and their equivalents should be understood as defining the scope and spirit of the present disclosure.

## Claims

1. A semiconductor device, comprising:
an interposer;
a High Bandwidth Memory (HBM) module and a semiconductor module disposed to be spaced apart from each other on a top of the interposer; and
an HBM switch chiplet disposed under the interposer and configured to electrically connect the HBM module and the semiconductor module.

2. The semiconductor device of claim 1, wherein the HBM switch chiplet includes a first connection wire configured to electrically connect the HBM switch chiplet and the HBM module by passing through the interposer.

3. The semiconductor device of claim 2, wherein the first wire perpendicularly passes through the interposer.

4. The semiconductor device of claim 3, wherein a length of the first wire is 40 to 50 µm.

5. The semiconductor device of claim 1, wherein the HBM switch chiplet includes a second connection wire configured to electrically connect the HBM switch chiplet and the semiconductor module by passing through the interposer.

6. The semiconductor device of claim 5, wherein the second connection wire includes a shield wire.

7. The semiconductor device of claim 5, wherein the second connection wire includes at least one vertical part and at least one horizontal part.

8. The semiconductor device of claim 5, wherein the semiconductor device includes a number of ground wires corresponding to a number of second connection wires.

9. The semiconductor device of claim 8, wherein the ground wires are connected to the interposer.

10. The semiconductor device of claim 1, wherein a number of HBM switch chiplets corresponding to a number of HBM moules are disposed.

11. A semiconductor package, comprising:
a base substrate;
an interposer disposed on the base substrate;
a High Bandwidth Memory (HBM) module and a semiconductor module disposed to be spaced apart from each other on a top of the interposer; and
an HBM switch chiplet disposed under the interposer and configured to electrically connect the HBM module and the semiconductor module.

12. The semiconductor package of claim 11, wherein the HBM switch chiplet includes a first connection wire configured to electrically connect the HBM switch chiplet and the HBM module by passing through the interposer.

13. The semiconductor package of claim 12, wherein the first wire perpendicularly passes through the interposer.

14. The semiconductor package of claim 13, wherein a length of the first wire is 40 to 50 µm.

15. The semiconductor package of claim 11, wherein the HBM switch chiplet includes a second connection wire configured to electrically connect the HBM switch chiplet and the semiconductor module by passing through the interposer.

16. The semiconductor package of claim 15, wherein the second connection wire includes a shield wire.

17. The semiconductor package of claim 15, wherein the second connection wire includes at least one vertical part and at least one horizontal part.

18. The semiconductor package of claim 15, wherein the semiconductor package includes a number of ground wires corresponding to a number of second connection wires.

19. The semiconductor package of claim 18, wherein the ground wires are connected to the interposer.

20. The semiconductor package of claim 11, wherein a number of HBM switch chiplets corresponding to a number of HBM modules are disposed.
